# EUROPÄISCHE PATENTSCHRIFT

(11) **EP 2 002 475 B1**
(45) Veröffentlichungstag und Bekanntmachung des Hinweises auf die Patenterteilung: **04.05.2016**
(21) Anmeldenummer: 07723044.9
(22) Anmeldetag: 06.03.2007
(51) Int. Cl.: H01L 21/78, H01L 21/304, H01L 21/02

(54) **VERFAHREN ZUM HERSTELLEN EINER INTEGRIERTEN SCHALTUNG**
METHOD FOR PRODUCING AN INTEGRATED CIRCUIT
PROCÉDÉ POUR PRODUIRE UN CIRCUIT INTÉGRÉ

(30) Priorität: 14.03.2006 DE 102006013419; 08.12.2006 DE 102006059394
(43) Veröffentlichungstag der Anmeldung: 17.12.2008
(73) Patentinhaber: INSTITUT FÜR MIKROELEKTRONIK STUTTGART, 70569 Stuttgart (DE)
(72) Erfinder: BURGHARTZ, Joachim, N., 70771 Leinfelden-Echterdingen (DE); ZIMMERMANN, Martin, 70563 Stuttgart (DE); APPEL, Wolfgang, 71701 Schwieberdingen (DE)
(74) Vertreter: Witte, Weller & Partner Patentanwälte mbB
(86) Internationale Anmeldenummer: PCT/EP2007/001886
(87) Internationale Veröffentlichungsnummer: WO 2007/104443

(56) Entgegenhaltungen:
- DE-A1- 10 019 705
- FR-A1- 2 823 596
- US-B2- 6 774 010

## Beschreibung

Die vorliegende Erfindung betrifft ein Verfahren zum Herstellen einer integrierten Schaltung, mit den Schritten:
- Bereitstellen eines Halbleiterwafers mit einer ersten und einer zweiten Oberfläche,
- Erzeugen eines Waferhohlraums unter zumindest einem definierten Waferabschnitt im Bereich der ersten Oberfläche, indem zunächst ein Substratwafer bereitgestellt wird, der im Bereich des definierten Waferabschnitts mit Hilfe eines anodischen Ätzprozesses in poröses Silizium mit einer Vielzahl von Poren umgewandelt wird, und indem das poröse Silizium anschließend einer Wärmebehandlung unterzogen wird, in deren Verlauf sich die Poren an der ersten Oberfläche zumindest weitgehend wieder schließen, wobei das dazu erforderliche Material aus einer tiefer liegenden Schicht des porösen Siliziums stammt,
- Erzeugen einer Schaltungsstruktur in dem definierten Waferabschnitt, und
- Heraustrennen des definierten Waferabschnitts aus dem Halbleiterwafer, wobei der Waferabschnitt in einem ersten Prozessablauf so freigestellt wird, dass er nur noch über stegartige Verbindungen an dem verbleibenden Halbleiterwafer gehalten wird, und wobei die stegartigen Verbindungen in einem zweiten Prozessablauf aufgetrennt werden.

Ein solches Verfahren ist aus US 2005/0029224 A1 bekannt.

Die vorliegende Erfindung betrifft insbesondere ein Verfahren zum Herstellen von sogenannten Chips mit einer integrierten elektronischen Schaltung, wobei die Chips bzw. das Chipmaterial sehr dünn sind. Erfindungsgemäße Chips können eine Dicke von deutlich weniger als 100 µm besitzen, vorteilhafterweise eine Dicke von etwa 50 µm und weniger, besonders bevorzugt eine Dicke von etwa 20 µm. Derartig dünne Chips eignen sich gut zur Herstellung von sogenannten 3D-Chips, bei denen mehrere dünne Chips mit jeweils einer integrierten Schaltung aufeinander gestapelt werden. Darüber hinaus besitzen derartig dünne Chips aufgrund der geringen Materialstärke eine gewisse Flexibilität, so dass sie auf flexiblen Trägermaterialien, wie z.B. einer Kunststofffolie, verwendet werden können.

Eine Möglichkeit, um derartig dünne Chips mit einer integrierten Schaltung herzustellen, besteht darin, die integrierte Schaltung zunächst auf einem Halbleiterwafer mit einer Dicke von bspw. 500 µm bis zu 800 µm herzustellen. Nach der Herstellung der integrierten Schaltung wird die Rückseite des Halbleiterwafers durch einen mechanischen und/oder chemischen Prozess abgetragen. Anschließend muss der Halbleiterwafer, der typischerweise eine Vielzahl von integrierten Schaltungen trägt, zu den Chips vereinzelt werden. Herkömmlicherweise geschieht dies durch Sägen, Trennschleifen, Schneiden oder Ritzen und Brechen. Ein Verfahren zum Vereinzeln von Halbleiterwafern zu Chips ist in DE 40 29 973 A1 beschrieben.

Die beschriebene Vorgehensweise besitzt den Nachteil, dass ein erheblicher Teil des Wafermaterials durch den Abtrag ungenutzt verloren geht. Des weiteren müssen relativ große Abstände zwischen den einzelnen Chips auf einem Wafer vorgesehen werden, damit genügend Platz zum Sägen, Trennschleifen etc. zur Verfügung steht. Typische Abstände liegen hier in einer Größenordnung von 150 µm. Dies alles wirkt sich nachteilig auf die Kosten für die Herstellung von dünnen integrierten Schaltungen aus, d.h. Chips mit Materialstärken von weniger als 150 µm.

WO 2005/104223 A1 beschreibt ein Verfahren, bei dem an der ersten Oberfläche des Halbleiterwafers zunächst eine Vielzahl von vertikalen Gräben durch einen anisotropen Ätzprozess hergestellt werden. Anschließend wird die geöffnete erste Oberfläche durch eine Epitaxieschicht wieder verschlossen und der Halbleiterwafer wird einer Wärmebehandlung (Annealing) unterzogen. Hierdurch sollen einzelne geschlossene Kanäle unterhalb der ersten Oberfläche gebildet werden. In einem weiteren anisotropen Ätzprozess werden dann vertikale Zugänge zu den verborgenen Kanälen geschaffen. Anschließend werden die Innenwände der Kanäle und der vertikalen Zugänge durch einen Oxidationsprozess mit einer Oxidschicht versehen. Die Kanäle und vertikalen Zugänge umgeben einen Waferabschnitt an der ersten Oberfläche, in dem dann in herkömmlicher Weise eine Schaltungsstruktur erzeugt wird. Daran anschließend wird die Oxidschicht in den Kanälen und vertikalen Zugängen durch einen weiteren Ätzprozess entfernt, so dass der Waferabschnitt nur noch über stegartige Verbindungen an seiner Unterseite mit dem Rest des Wafers verbunden ist. Diese Verbindungen werden aufgebrochen, indem der Waferabschnitt nach oben aus dem verbleibenden Halbleiterwafer herausgerissen wird, wobei ergänzend auch eine Torsionsbewegung vorgeschlagen wird. Mit diesem Verfahren sollen Chips mit einer Dicke von weniger als 10 µm hergestellt werden können.

Bei diesem bekannten Verfahren ist die Erzeugung der tiefliegenden Oxidschichten unter dem Waferabschitt sowie deren späteres, selektives Herausätzen aufwändig und schwierig. Außerdem besitzt dieses Verfahren den Nachteil, dass die Ausbildung der stegartigen Verbindungen in hohem Maße von individuellen Prozessparametern abhängt, die in vielfältiger Weise variieren können. Daher ist die Ausbildung von stegartigen Verbindungen mit exakt definierten Eigenschaften äußerst schwierig, wenn überhaupt möglich. Geraten die stegartigen Verbindungen zu dick, besteht eine erhebliche Gefahr, dass der Chip beim Herausbrechen beschädigt wird. Geraten sie zu dünn, fehlt die notwendige Stabilität für die Erzeugung der Schaltungsstruktur.

Die Reproduzierbarkeit der stegartigen Verbindungen und die Prozesssicherheit ist daher nur mit sehr großem Aufwand zu gewährleisten, wenn überhaupt.

Aus einem Aufsatz von Overstolz et al. mit dem Titel "A Clean Wafer-Scale Chip-Release Process without Dicing Based on Vapor Phase Etching", 17th IEEE International Conference on Micro Electro Mechanical Systems, Januar 2004, Seiten 717 bis 720, ist es bekannt, einen mikromechanischen Sensor, nämlich einen Neigungsmesser, allein durch verschiedene Ätzprozesse aus einem Siliziummaterial herauszulösen. Als Ausgangsmaterial dient hier ein SOI-Wafer (Silicon on Insulator). Zum Herauslösen des Neigungssensors werden Gräben und Löcher sowohl von der Vorderseite als auch von der Rückseite des Wafermaterials geätzt. Außerdem wird die im Halbleitermaterial liegende Oxidschicht teilweise ausgeätzt, indem Flusssäuredampf durch die Löcher an der Vorderseite und Rückseite in das Innere des Halbleiterwafers gebracht wird.

US 6,165,813 beschreibt ein Verfahren zum Lösen von dünnen Chips, die an einem flexiblen Substrat befestigt sind, indem das Substrat gebogen wird. US 6,521,068 beschreibt ein Verfahren zum Vereinzeln von Chips von einem Substrat, wobei ein Bereich unterhalb des Chips mit einem Laser erhitzt wird.

JP 2002-299500 beschreibt die Entnahme von Chips mit Hilfe eines sogenannten Dummy-Substrates.

Schließlich ist im Stand der Technik die Erzeugung und Verwendung von porösem Silizium bekannt. DE 197 52 208 A1 offenbart ein Verfahren zur Herstellung eines Membransensors, wobei eine dünne Schicht aus Siliziumcarbid oder Siliziumnitrit über einem Bereich aus porösem Silizium abgeschieden wird. Das poröse Silizium wird anschließend als Opfermaterial mit Ammoniak entfernt. Dadurch entsteht unter der Membranschicht aus Siliziumcarbid oder Siliziumnitrit ein Hohlraum, der die Sensormembran vom verbleibenden Substrat thermisch entkoppelt.

Ein ähnliches Verfahren zum Herstellen eines piezo-resistiven Drucksensors mit einer frei aufgehängten Membran aus monokristallinem Silizium ist in einer Veröffentlichung von Armbruster et al., "Surface Micromachining of Monocrystalline Silicon Membranes Using a Silicon Micro Grid of Sintered Porous Silicon", Technical Digest of Eurosensors XVIII, Rom, 12. bis 15. September 2004, Seiten, 22/23, beschrieben. Bei diesem Verfahren wird ein p-dotiertes Siliziumsubstrat in einem ersten Schritt mit flachen n-dotierten Regionen und mit tiefen n⁺-dotierten Regionen versehen. Die flachen n-dotierten Regionen bilden eine Gitterstruktur an der Oberfläche des p-dotierten Siliziumsubstrats. Anschließend wird das p-dotierte Siliziumsubstrat unterhalb der Gitterstruktur in poröses Silizium umgewandelt. Dazu werden die Bereiche des p-dotierten Substrats unterhalb der n-dotierten Gitterbereiche in konzentrierter Flusssäure unterätzt. Ein anschließender Sinterprozess führt dazu, dass das gesinterte poröse Silizium einen Hohlraum unterhalb der Gitterstruktur ausbildet. Über der Gitterstruktur wird anschließend eine Epitaxieschicht aufgebracht, die die Sensormembran des Drucksensors bildet. Der mit Hilfe des porösen Siliziums gebildete Hohlraum wird auf diese Weise wieder verschlossen.

Des Weiteren wird poröses Silizium beim sog. ELTRAN-Prozess (Epitaxial Layer TRANsfer) verwendet, mit dessen Hilfe SOI-Wafer hergestellt werden können. Die Vorgehensweise ist in einer Veröffentlichung von T. Yonehara und K. Sakaguchi beschrieben, die unter dem Titel "ELTRAN; Novel SOI-Wafer Technology" in JSAP International No. 4, Juli 2001 erschienen ist.

Die eingangs genannte US 2005/0029224 A beschreibt verschiedene Varianten, um ein dünnes Substrat, in dem ggf. eine Schaltungsstruktur erzeugt wird, von einem dickeren Trägersubstrat abzulösen. In einigen Varianten wird die Trennschicht mit Hilfe von porösem Silizium erzeugt, das in Form eines verborgenen Hohlraums in dem Ausgangssubstrat eingebettet ist. Stützstellen mit höherer Tragkraft sollen ggf. durch Herstellen von unterschiedlichen Porositäten erzeugt werden. Hierbei können auch lokale thermische Behandlungen zur Anwendung kommen. Wenn mehrere Schaltungsstrukturen in der abzulösenden Substratschicht erzeugt werden, können vertikale Gräben bis auf die Tiefe der Trennschicht erzeugt werden, um die Schaltungsstrukturen anschließend mit Hilfe eines Greifwerkzeugs abzuheben. Die Separation der Schaltungsstrukturen aus den Substrat soll in diesem Fall durch Zugabe von Ätzmittel erleichtert werden.

US 6,774,010 B2 beschreibt ein weiteres Verfahren, bei dem poröses Silizium zur Ausbildung einer Trennschicht zwischen einer oberen Substratlage und einem unteren Substratkörper zur Anwendung kommt. Details, die sich auf eine Vereinzelung von Schaltungsstrukturen aus einen Wafer beziehen, sind hier nicht offenbart.

DE 100 19 705 A1 schlägt die Verwendung von porösem Silizium unterhalb der Source- und Drainbereiche eines MOS-Transistors vor, um größere Raumladungszonen im Bereich der pn-Übergänge zu erhalten. Ein solcher MOS-Transistor soll einen schnelleren Betrieb und einen geringeren Stromverbrauch ermöglichen.

Vor diesem Hintergrund ist es eine Aufgabe der vorliegenden Erfindung, ein alternatives Verfahren anzugeben, um dünne integrierte Schaltungen möglichst kostengünstig und mit hoher Qualität und Ausbeute herzustellen. Es ist außerdem eine Aufgabe der Erfindung, eine integrierte Schaltung anzugeben, die sich mit einem solchen Verfahren einfach und kostengünstig herstellen lässt.

Diese Aufgabe wird gemäß einem Aspekt der vorliegenden Erfindung durch ein Verfahren der eingangs genannten Art gelöst, bei dem der Substratwafer im Bereich der ersten Oberfläche aus p-dotiertem Silizium besteht, wobei in dem p-dotierten Silizium des Substratwafers eine Vielzahl von lokalen, n-dotierten Bereichen erzeugt wird, bevor das p-dotierte Silizium mit Hilfe des anodischen Ätzprozesses in poröses Silizium umgewandelt wird, wobei eine erste Gruppe von punktuellen n-dotierten Bereichen erzeugt wird, wobei zumindest ein punktueller n-dotierter Bereich im Bereich des definierten Waferabschnitts angeordnet ist, und wobei ein ringförmiger n-dotierter Bereich erzeugt wird, der konzentrisch an der Peripherie des Substratwafers angeordnet wird, wobei die punktuellen n-dotierten Bereiche innerhalb des ringförmigen n-dotierten Bereichs weitgehend gleichmäßig verteilt sind.

Es wird hiernach eine Vielzahl von lokalen, n-dotierten Bereichen in dem p-dotierten Silizium des Substratwafers erzeugt, bevor das p-dotierte Silizium mit Hilfe des anodischen Ätzprozesses in poröses Silizium umgewandelt wird. Dies ist besonders bevorzugt, weil n-dotierte Bereiche im Verlauf des anodischen Ätzprozesses nicht angegriffen werden. Daher lassen sich die Lage und die Abmessungen der stegartigen Verbindungen sehr exakt einstellen.

Dabei wird eine Gruppe von punktuellen n-dotierten Bereichen erzeugt, wobei zumindest ein punktueller n-dotierter Bereich im Bereich des definierten Waferabschnitts angeordnet ist. Damit lassen sich sehr exakte stegartige Verbindungen an der Unterseite der definierten Waferabschnitte ausbilden. Solche vertikalen Stege an der Unterseite verhindern oder zumindest reduzieren eine starke Durchbiegung des Materials über dem Hohlraum. Daher ermöglicht diese Ausgestaltung eine sehr flexible Gestaltung des Prozessablaufs sowie eine stabile Aufhängung der Waferabschnitte während der Erzeugung der Schaltungsstrukturen.

Es wird zudem ein ringförmiger n-dotierter Bereich konzentrisch zu dem Substratwafer angeordnet, wobei die punktuellen n-dotierten Bereiche innerhalb des ringförmigen n-dotierten Bereichs weitgehend gleichmäßig verteilt sind. Diese Ausgestaltung ermöglicht es, vertikale stegartige Verbindungen an der gesamten Oberfläche des Halbleiterwafers vorzubereiten, ohne feste Facetten oder Unterteilungen vorzunehmen. Der Anwender erhält damit die Möglichkeit, die Chipfläche der zukünftigen Chips individuell zu bestimmen, da die gesamte Oberfläche des Wafers, die innerhalb des ringförmigen n-dotierten Bereichs liegt, frei aufgehängt werden kann. Daher lassen sich auch Chips mit unterschiedlicher Chipfläche auf einem Wafer individuell herstellen.

Das neue Verfahren besitzt den Vorteil, dass die stegartigen Verbindungen, die die einzelnen definierten Waferabschnitte vor dem Auftrennen halten, sehr exakt dimensioniert und platziert werden. Stegartige Verbindungen unterhalb der definierten Waferabschnitte stützen den im Übrigen freigestellten Waferabschnitt säulenartig nach unten auf dem verbleibenden Halbleiterwafer ab, wie dies prinzipiell aus der eingangs genannten WO 2005/104223 A1 bekannt ist. Im Gegensatz zu der dort beschriebenen Vorgehensweise lassen sich mit der Erfindung tiefliegende, vertikale, stegartige Verbindungen innerhalb des Waferhohlraums sehr einfach und mit einer hohen Reproduzierbarkeit erstellen, wie im Folgenden anhand eines bevorzugten Ausführungsbeispiels beschrieben ist. Darüber hinaus können mit derselben Technologie und in einer gemeinsamen Prozessabfolge vertikale, laterale als auch beide Varianten von stegartigen Verbindungen hergestellt werden, so dass das neue Verfahren wesentlich flexibler in Bezug auf die Aufhängung der zukünftigen Chips ist. Die Aufhängung" der zukünftigen Chips kann daher besser auf die nachfolgenden Prozessschritte optimiert werden, indem stegartige Verbindungen unterhalb der definierten Waferabschnitte angeordnet werden. Damit lassen sich die Stabilität des Wafers und das Bruchverhalten der Chips beim Heraustrennen optimieren.

Insgesamt ermöglicht das neue Verfahren somit eine gut beherrschbare, kostengünstige und qualitativ hochwertige Herstellung von dünnen integrierten Schaltungen. Die eingangs genannte Aufgabe ist daher vollständig gelöst.

In einer Ausgestaltung der Erfindung wird der Waferhohlraum unter dem definierten Waferabschnitt als geschlossener Waferhohlraum erzeugt.

In dieser Ausgestaltung ist der Waferhohlraum nach außen abgeschlossen und folglich im Halbleiterwafer verborgen. Es gibt keine bewussten Zugänge von außen in den Hohlraum. Ein solcher Hohlraum besitzt den Vorteil, dass der Halbleiterwafer der Hohlräume auf Lager bevorratet werden kann, wodurch der Produktionsprozess besser rationalisiert und noch kostengünstiger gemacht werden kann.

Besonders bevorzugt ist es, wenn der Waferhohlraum während des gesamten Produktionsprozesses als geschlossener Hohlraum ausgebildet ist, weil dann ein Eindringen von Verunreinigungen in den Hohlraum ausgeschlossen ist. Diese bevorzugte Ausgestaltung lässt sich mit Hilfe des porösen Siliziums gut realisieren, da die Porenbildung bei dem anodischen Ätzprozess in Abhängigkeit vom Anodenstrom und der Einwirkzeit variiert werden kann. Mit anderen Worten ist der Waferhohlraum hier stets von porösem Halbleitermaterial bedeckt. Das poröse Halbleitermaterial besitzt zwar Poren. Diese Poren stellen jedoch räumlich sehr eng begrenzte Öffnungen dar, die über eine relativ große Fläche bezogen auf die Porengröße breit gestreut sind. Es befindet sich daher eine weitgehend geschlossene Decke über dem Hohlraum. Diese Ausgestaltung führt zu einer sehr gleichmäßigen Oberfläche oberhalb der Hohlräume, so dass das für die Erzeugung der Schaltungsstrukturen zur Verfügung stehende Halbleitermaterial qualitativ hochwertiger ist. Daher ermöglicht diese Ausgestaltung eine weitere Steigerung der Ausbeute.

In einer weiteren Ausgestaltung wird nach der Wärmebehandlung eine Epitaxieschicht auf das poröse Silizium aufgebracht, wobei die Schaltungsstruktur zumindest überwiegend in der Epitaxieschicht erzeugt wird. Vorzugsweise ist die Schaltungsstruktur vollständig in der Epitaxieschicht angeordnet.

In den bevorzugten Ausgestaltungen der Erfindung wird die Epitaxieschicht vollflächig auf der gesamten Oberfläche des Halbleiterwafers erzeugt, so dass sich ein Halbleiterwafer ergibt, der einerseits verborgene Hohlräume und andererseits eine sehr gleichmäßige, vorzugsweise monokristalline Oberfläche besitzt. Eine solche Oberfläche ist von Vorteil, weil sie eine weitgehend fehlerfreie Erzeugung der Schaltungsstrukturen mit einer hohen Ausbeute erleichtert. Jede Störstelle im Halbleitermaterial an der Oberfläche des Wafers birgt das Risiko von Prozessfehlern, die die Ausbeute verschlechtern. In den bevorzugten Ausgestaltungen der Erfindung wird die Epitaxieschicht auf einer weitgehend ebenen Oberfläche erzeugt, was einen wesentlichen Vorteil gegenüber dem Verfahren aus WO 2005/104223 A1 darstellt.

In der Ausgestaltung der Erfindung einer weiteren Ausgestaltung wird der definierte Waferabschnitt nach dem Erzeugen der Schaltungsstruktur so freigestellt, dass stegartige Verbindungen an einer seitlichen Peripherie des Waferabschnitts entstehen. Vorzugsweise wird der definierte Waferabschnitt freigestellt, indem an den Seiten des Waferabschnitts Gräben in die Tiefe des Wafers hineingeätzt werden, und zwar vorzugsweise durch einen anisotropen Ätzprozess.

Seitliche stegartige Verbindungen besitzen den Vorteil, dass der definierte Waferabschnitt relativ leicht mit Hilfe von Scherkräften aus dem verbleibenden Halbleiterwafer herausgebrochen werden kann. Die Gefahr von Beschädigungen der Schaltungsstruktur im definierten Waferabschnitt ist hierbei vergleichweise gering. Des Weiteren lässt sich durch die Wahl des seitlichen Abstandes zwischen den stegartigen Verbindungen und den Flächenbereichen, in denen die Schaltungsstrukturen erzeugt werden, ein frei wählbarer "Sicherheitsabstand" einstellen, was auf einfache Weise dazu beiträgt, die Ausbeute weiter zu steigern. Außerdem verlegen seitliche stegartige Verbindungen die Bruchstellen an die seitliche Peripherie der Chips, so dass die Chipunterseiten relativ gleichmäßig ausgebildet werden können, was beim Stapeln von dünnen Chips von Vorteil ist.

In einer weiteren Ausgestaltung wird der Waferabschnitt in dem Halbleiterwafer in [100]-Richtung oder in [110]-Richtung angeordnet und die stegartigen Verbindungen werden an den Ecken oder Seitenkanten des Waferabschnitts angeordnet,

Diese Ausgestaltung ist bevorzugt, weil das Brechverhalten von Halbleiterwafern in Abhängigkeit von der Lage einer Bruchkante relativ zum Kristallgitter unterschiedlich ist. Mit dieser Ausgestaltung lassen sich die Kräfte, die zum Auftrennen von seitlichen stegartigen Verbindungen benötigt werden, minimieren, wodurch die Gefahr ungewollter Beschädigungen weiter minimiert wird.

In einer weiteren Ausgestaltung wird das p-dotierte Silizium im Bereich des definierten Waferabschnitts mit Hilfe des anodischen Ätzprozesses in eine obere Schicht aus porösem Silizium mit einer Vielzahl von feineren Poren und in eine untere Schicht mit einer Vielzahl von größeren Poren umgewandelt.

Die Eindringtiefe und Porengröße der Schichten kann beim Herstellen der porösen Bereiche variiert werden, indem bspw. die Stromdichte desjenigen Stroms variiert wird, der durch eine Flusssäurelösung zu dem als Anode verwendeten Substratwafer fließt. Indem man eine großporige untere (tiefer liegende) Schicht und eine feinporige obere (höher liegende) Schicht erzeugt, lässt sich ein verborgener Waferhohlraum ausbilden, ohne dass die Oberseite des Halbleiterwafers vollständig geöffnet werden muss. Dies ist von Vorteil, weil sich damit eine höhere Materialqualität an der Oberfläche des Halbleiterwafers erzeugen lässt. Infolgedessen kann die Ausbeute weitergesteigert werden.

In einer weiteren Ausgestaltung wird ein Substratwafer bereitgestellt, der an der ersten Oberfläche eine obere Schicht und eine darunter liegende untere Schicht aufweist, wobei die obere Schicht ein stärker p-dotiertes Silizium ist als die untere Schicht. Vorteilhafterweise wird das poröse Silizium in der stärker p-dotierten oberen Schicht ausgebildet, wohingegen die schwächer p-dotierte untere Schicht lediglich als tragendes Substratmaterial dient.

Die Ausgestaltung ist von Vorteil, weil sich mit Hilfe der unterschiedlichen Dotierungen Materialspannungen ausgleichen lassen, die aufgrund der Ausbildung des oder der Waferhohlräume zwangsläufig entstehen. Durch die unterschiedlichen Dotierungen lassen sich Bruchschäden aufgrund solcher Materialspannungen vermeiden.

In einer weiteren Ausgestaltung wird der verbleibende Halbleiterwafer nach dem Heraustrennen des definierten Waferabschnitts abgeschliffen und als Substratwafer für die Herstellung von weiteren integrierten Schaltungen bereitgestellt.

Diese Ausgestaltung ist besonders vorteilhaft, weil sie eine effiziente Ausnutzung des Halbleitermaterials ermöglicht. Daher führt diese Ausgestaltung zu einer besonders kostengünstigen Herstellung von dünnen Chips mit integrierten Schaltungen.

Die Erfindung bezieht sich auch auf ein Substratwafer gemäß Anspruch 11. Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ausführungsbeispiele der Erfindung sind in der Zeichnung dargestellt und werden in der nachfolgenden Beschreibung näher erläutert. Es zeigen:
- Fig. 1: eine vereinfachte Darstellung zur Erläuterung eines Beispiels des Standes der Technik.

- Fig. 2: eine vereinfachte Darstellung zur Erläuterung der Prozessfolge, mit deren Hilfe ein Waferhohlraum unter einem definierten Waferabschnitt erzeugt wird,

- Fig. 3: eine schematische Draufsicht auf einen Halbleiterwafer, das nicht Teil der Erfindung ist.

- Fig. 4: eine schematische Darstellung der Vereinzelung der Chips in einer bevorzugten Variante des neuen Verfahrens,
- Fig. 5: einen Ausschnitt aus dem Halbleiterwafer aus Fig. 3 in einem seitlichen Querschnitt,
- Fig. 6: einen Teil eines vereinzelten Chips mit einer integrierten Schaltung in einem seitlichen Querschnitt ähnlich wie in Fig. 5, und
- Fig. 7: eine schematische Draufsicht auf einen Halbleiterwafer gemäß dem neuen Verfahren, wobei ein großer Hohlraum innerhalb einer ringförmigen Begrenzungswand vorgesehen ist.

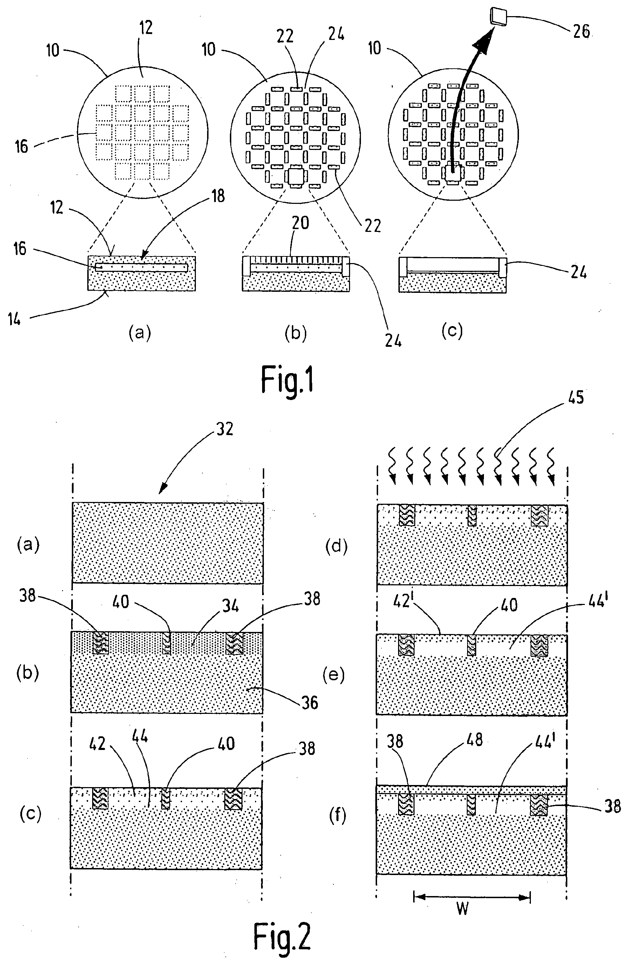

In Fig. 1 ist ein Halbleiterwafer mit der Bezugsziffer 10 bezeichnet. Der Halbleiterwafer 10 besitzt eine erste Oberfläche 12 und eine gegenüberliegende zweite (untere) Oberfläche 14. Unterhalb der ersten Oberfläche 12 ist ein Hohlraum 16 angeordnet, so dass ein Waferabschnitt 18 oberhalb des Hohlraums "hängend" gelagert ist. Wie in Fig. 1a) dargestellt ist, besitzt der Halbleiterwafer hier eine Vielzahl solcher Hohlräume 16, die im Inneren des Halbleitermaterials verborgen sind.

In diesem Beispiel wird in den Waferabschnitten 18 oberhalb der Hohlräume 16 jeweils eine Schaltungsstruktur in herkömmlicher Weise erzeugt. Die Schaltungsstruktur ist in Fig. 1b bei der Bezugsziffer 20 schematisch dargestellt. Sie liegt in bevorzugten Beispielen in [100]- oder [110]-Richtung bezogen auf das Kristallgitter des Wafermaterials. Der Waferabschnitt 18 mit der Schaltungsstruktur 20 bildet einen zukünftigen Chip mit einer integrierten Schaltung, der nun aus dem Halbleiterwafer 10 herausgelöst werden muss.

Dies geschieht dadurch, dass eine Vielzahl von Gräben 22 in die Oberfläche 12 des Halbleiterwafers 10 hineingeätzt werden, wobei die einzelnen Gräben 22 durch stegartige Bereiche 24 voneinander getrennt sind. In dem bevorzugten Beispiel sind die Gräben 22 gitterartig auf der Oberfläche 12 des Halbleiterwafers 10 verteilt und sie bilden ein Muster aus senkrechten und waagerechten Gräben. Dort, wo ein senkrechter und ein waagerechter Graben 22 zusammentreffen, ist ein stegartiger Bereich 24 verblieben, der nicht ausgeätzt wurde. Jeweils vier Gräben umgeben einen Waferabschnitt 18 mit der integrierten Schaltungsstruktur 20. Dementsprechend ist hier jeder Waferabschnitt 18 an seinen vier Ecken durch die stegartigen Verbindungen 24 gehalten. Alternativ könnten die Waferabschnitte 18 auch über stegartige Verbindungen gehalten werden, die nicht an den Ecken, sondern zum Beispiel mittig an den Seitenkanten jedes Waferabschnitts 18 angeordnet sind. Ergänzend zu den stegartigen Bereichen 24 an der seitlichen Peripherie der einzelnen Waferabschnitte 18 sind auch noch stegartige Verbindungen an der Unterseite der einzelnen Waferabschnitte vorgesehen, wie dies im Folgenden anhand der Figuren 2, 5 und 6 beschrieben wird. Das neue Verfahren macht es möglich, stegartige Verbindungen wahlweise nur unterhalb der definierten Waferabschnitte 18 oder kombiniert sowohl unten als auch an der seitlichen Peripherie anzuordnen.

Wie in Fig. 1c dargestellt ist, können die einzelnen Waferabschnitte 18 aus dem Gitterraster der Gräben 22 herausgebrochen werden, und man erhält auf diese Weise Chips 26 mit einer integrierten Halbleiterstruktur.

Fig. 2 zeigt ein bevorzugtes Beispiel um einen Halbleiterwafer 10 nach Fig. 1 herzustellen. Gemäß Fig. 2 wird zunächst ein Substratwafer 32 bereitgestellt, der aus monokristallinem, schwach p-dotierten Silizium besteht. Gemäß Fig. 2b wird der Substratwafer 32 an seiner Oberseite mit einer oberen Schicht 34 aus stärker p-dotiertem Silizium versehen. In bevorzugten Ausführungsbeispielen geschieht dies, indem die Oberseite des Substratwafers 32 in bekannter Weise mit weiteren Dotieratomen versehen wird, wobei die Dotierung hier bei etwa 10¹⁸ liegen kann. Der Substratwafer 32 besitzt nun eine obere Schicht 34 mit einer stärkeren p-Dotierung und eine untere Schicht 36 mit einer schwächeren p-Dotierung. Außerdem werden in der oberen Schicht 34 n-dotierte Bereiche 38, 40 ausgebildet. Vorzugsweise handelt es sich hier um n⁺-dotierte Bereiche, d.h. die Bereiche 38, 40 sind mit einer hohen Konzentration an n-Dotieratomen versehen. Die Ausbildung der Bereiche 38, 40 kann mit bekannten Verfahren erfolgen, wie z.B. der Ionenimplantation oder einem anderen Verfahren mit herkömmlicher Maskentechnik.

Gemäß Fig. 2c werden anschließend poröse Schichten 42, 44 in der stark p-dotierten Schicht 34 erzeugt. Dazu wird der Substratwafer 32 in einem bevorzugten Ausführungsbeispiel als Anode in eine Lösung aus Flusssäure und Alkohol gegeben, so dass ein Strom durch die Lösung zu dem Substratwafer fließen kann. Hierdurch bildet sich poröses Silizium im Bereich der oberen Schicht 34, wobei die Porengröße durch Variation der Stromdichte verändert werden kann. In dem bevorzugten Ausführungsbeispiel wird eine feinporige Schicht 42 an der Oberfläche des Substratwafers und eine großporige Schicht 44 darunter erzeugt. Eine genauere Beschreibung der Herstellung dieser Schichten ist in der eingangs erwähnten Veröffentlichung von Yonehara/Sakaguchi enthalten, auf die hier in Bezug auf die Herstellung von porösen Siliziumschichten ausdrücklich Bezug genommen ist.

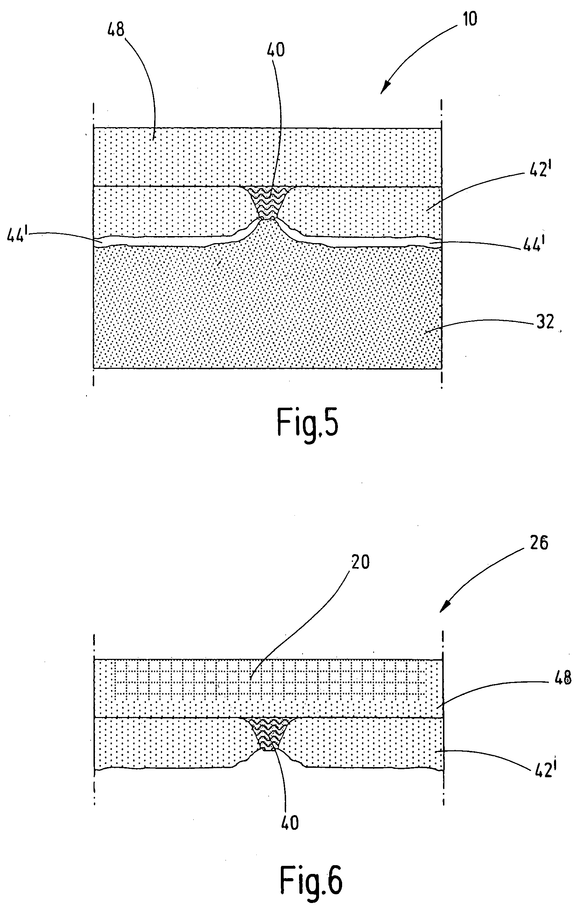

Gemäß Fig. 2d wird der Wafer mit den porösen Schichten 42, 44 dann einer Wärmebehandlung 45 ausgesetzt, bspw. bei etwa 1100 °C. Dies hat zur Folge, dass sich die Poren in der oberen feinporigen Schicht 42 zumindest weitgehend wieder schließen, so dass die obere Schicht 42 wieder in eine weitgehend gleichmäßige, monokristalline Schicht 42' umgeformt wird. Darunter liegt die 44', deren Porengröße sich so stark vergrößert hat, dass man kaum noch von einer Materiallage sprechen kann. Die großporige Schicht 44' bildet nun den Hohlraum, der in Fig. 1 mit der Bezugsziffer 16 bezeichnet ist. Innerhalb dieses Hohlraums können noch vereinzelte Stege (hier nicht dargestellt) verblieben sein, die die obere Schicht 42' mit dem unten liegenden Substratmaterial verbinden. Derartige Stege können die Folge von Prozessschwankungen und praktischen Begrenzungen beim Erzeugen des Hohlraums 16 sein. Darüber hinaus können vertikale Verbindungsstege mit Hilfe der n-dotierten Bereiche 40 gezielt erzeugt werden, wie weiter unten anhand der Figuren 5 und 6 anhand eines praktischen Beispiels noch näher erläutert ist.

Gemäß Fig. 2f wird als Nächstes eine weitere Schicht 48 als Deckschicht auf die Oberfläche der Schicht 42' aufgebracht. In einem bevorzugten Ausführungsbeispiel handelt es sich hier um eine monokristalline Epitaxieschicht mit einer für das spätere Bauelement angepassten Dotierung, die auf der gesamten Oberfläche des Wafers einschließlich der Schicht 42' aufgewachsen wird. Die Dotierung kann wahlweise vom n- oder p-Typ sein. Damit erhält man einen Halbleiterwafer 10, der für die Prozessschritte gemäß Fig. 1 als Ausgangsmaterial bereitgestellt wird.

Wie man in Fig. 2f erkennen kann, erstreckt sich der Hohlraum 44' zwischen den seitlich liegenden n-dotierten Bereichen 38, die gewissermaßen die seitlichen Begrenzungen des Hohlraums 44' bilden. Die laterale Flächenausdehnung des Hohlraums 44' ist hier mit W bezeichnet.

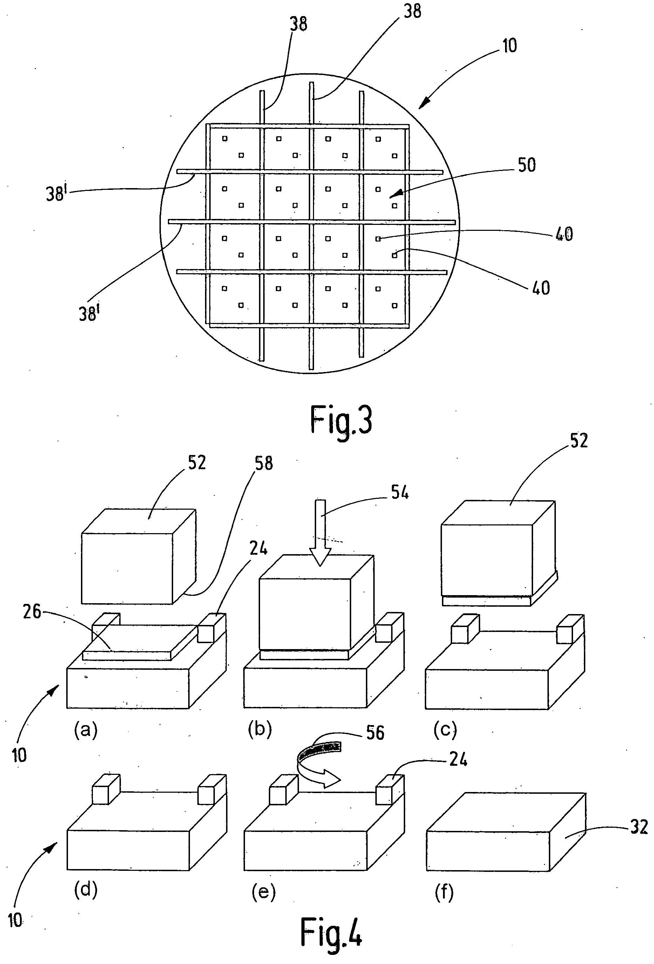

Fig. 4 zeigt ein bevorzugtes Ausführungsbeispiel zum Vereinzeln der Chips 26. Die Chips 26 werden hier mit Hilfe eines Greifwerkzeugs 52 erfasst, das die Chips 26 (genauer: die Waferabschnitte 18, die noch an den stegartigen Verbindungen 24 hängen) mit Vakuum ansaugt. Durch Druck von oben (Pfeil 54) werden die stegartigen Verbindungen 24 aufgebrochen, indem der einzelne Chip 26 nach unten in den Hohlraum gedrückt wird. Anschließend kann der Chip 26 mit dem Greifwerkzeug 50 nach oben abgenommen werden und weiterverarbeitet werden. Alternativ oder ergänzend kann der Chip 26 auch durch Zugkräfte und/oder Torsionskräfte aus dem Wafer 10 heraus gebrochen werden. Vorzugsweise ist das Greifwerkzeug ein Pick-and-Place-Werkzeug, wie es für die Handhabung von SMD Bauelementen verwendet wird

Zu den Vorteilen des in Fig. 1 und 2 dargestellten Verfahrens gehört es, dass der verbleibende Halbleiterwafer 10 nach der Entnahme aller Chips 26 recycelt werden kann. Hierzu wird der Halbleiterwafer 10 mit den verbliebenen Stegbereichen 24 (Fig. 4d) an seiner Oberseite abgeschliffen und poliert, was in Fig. 4e bei der Bezugsziffer 56 symbolisch dargestellt ist. Damit erhält man einen (etwas dünneren) Substratwafer 32, der erneut der Prozessabfolge aus Fig. 2 unterzogen werden kann.

Wie in Fig. 4 dargestellt ist, ergreift das Greifwerkzeug 52 die einzelnen Chips 26 weitgehend deckungsgleich. Dementsprechend ist das Greifwerkzeug 52 im Bereich seiner unteren Greiffläche 58 in etwa genauso groß ausgebildet wie die laterale Flächenausdehnung des Chips 26. Hierdurch kann das Greifwerkzeug 52 die empfindlichen Chips 26 sicher halten. Das Risiko von Beschädigungen beim Herausbrechen aus dem Halbleiterwafer 10 ist weiter minimiert.

In Fig. 5 ist ein Teilausschnitt des Wafers 10 in einer seitlichen, geschnittenen Ansicht dargestellt. Die Darstellung in Fig. 5 wurde der Aufnahme eines entsprechend aufgeschnittenen Wafers 10 mit Hilfe eines Elektronenmikroskops nachempfunden, da die Aufnahme selbst nicht in hinreichender Qualität vervielfältigt werden kann. Der guten Ordnung halber sei allerdings darauf hingewiesen, dass die Darstellung in Fig. 5 nicht exakt maßstabsgetreu ist. Gleiche Bezugszeichen bezeichnen dieselben Elemente wie zuvor.

Wie in Fig. 5 zu sehen ist, lassen sich mit Hilfe der beschriebenen Vorgehensweise verborgene Hohlräume 44' erzeugen, die eine relativ scharfe Trennung zwischen der darüber liegenden Schicht 42' und dem darunter liegenden Substratmaterial 32 bilden. Da die n-dotierten Bereiche, hier der Bereich 40, in dem anodischen Ätzprozess nicht angegriffen werden, enden die Hohlräume 44' an einem solchen n-dotierten Bereich. Wenn der n-dotierte Bereich eine lokale, punktförmige Ausdehnung besitzt, entsteht auf diese Weise ein lokaler, stegartiger Ankerpunkt, über den die Epitaxieschicht 48 auf dem tragenden Substratmaterial 32 abgestützt ist.

Fig. 6 zeigt einen Teilausschnitt aus einem Chip 26 mit einer integrierten Schaltungsstruktur 20, der nach dem neuen Verfahren hergestellt wurde. Wie man im Vergleich zu Fig. 5 erkennen kann, wurde der Chip 26 durch Aufbrechen der lokalen, stegartigen Verbindung 40 von dem darunter liegenden Substratmaterial 32 abgetrennt. Der Chip 26 besitzt folglich eine erste, obere Materiallage, die im Wesentlichen von der Epitaxieschicht 48 gebildet ist. In dieser Materiallage ist in den bevorzugten Ausführungsbeispielen die Schaltungsstruktur 20 implementiert. Darunter ist eine zweite, untere Materiallage 42' angeordnet, die im Wesentlichen von der früheren feinporigen und durch Materialanreicherung wieder weitgehend verschlossenen Schicht 42 gebildet wird. Auf der Unterseite der Schicht 42' ist eine gewisse Welligkeit oder Rauigkeit vorhanden, die sich vor allem an den Bruchstellen im Bereich der n-dotierten Bereiche 38, 40 ergibt.

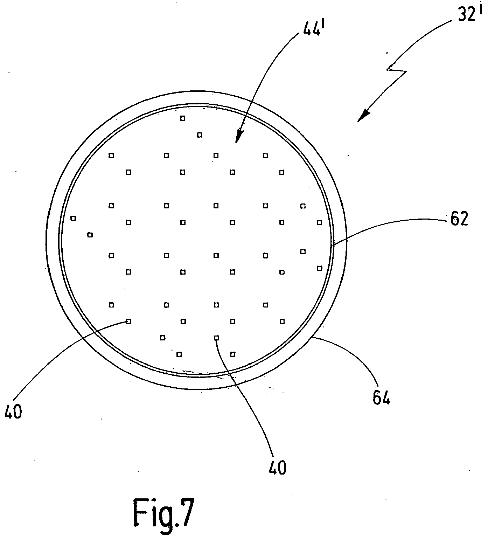

Fig. 7 zeigt die Draufsicht auf einen Substratwafer 32' gemäß der Erfindung einem ringförmigen n-dotierten Bereich 62, der in etwa konzentrisch an der Peripherie 64 des Wafers angeordnet ist. Innerhalb des ringförmigen n-dotierten Bereichs 62 sind eine Vielzahl von lokalen, punktuellen n-dotierten Bereichen 40 weitgehend gleichmäßig verteilt. Wenn nun bei diesem Substratwafer das poröse Silizium erzeugt wird, entsteht ein zusammenhängender, geschlossener Hohlraum, der sich über einen Großteil der gesamten Waferfläche erstreckt. Innerhalb dieses Hohlraums bilden die punktuellen n-dotierten Bereiche 40 vertikale Stützstellen, mit denen die poröse Schicht 42' nach unten abgestützt wird. Ein solcher Wafer ermöglicht es dem Anwender, die Flächenausdehnung seiner Chips 26 individuell und variabel zu gestalten. Daher eigent sich der Substratwafer 32' besonders gut für eine Bevorratung. Die einzelnen Chipflächen kann der Anwender dann durch vertikale Gräben 22, wie sie in Fig. 1 gezeigt sind, unterteilen. Aufgrund der vertikalen Stützstellen an den punktuellen n-dotierten Bereichen 40 kann man dabei auf seitliche stegartige Verbindungen 24 verzichten. Man kann jedoch auch zusätzlich noch seitliche stegartige Verbindungen 24 beim Ätzen der Gräben 22 stehen lassen, um eine noch stabilere Aufhängung der Chipfläche zu erhalten.

## Patentansprüche

1. Verfahren zum Herstellen einer integrierten Schaltung (26), mit den Schritten:
- Bereitstellen eines Halbleiterwafers (10) mit einer ersten und einer zweiten Oberfläche (12, 14),
- Erzeugen eines Waferhohlraums (16; 44') unter zumindest einem definierten Waferabschnitt (18) im Bereich der ersten Oberfläche (12), indem zunächst ein Substratwafer (32) bereitgestellt wird, der im Bereich des definierten Waferabschnitts (18) mit Hilfe eines anodischen Ätzprozesses in poröses Silizium (42, 44) mit einer Vielzahl von Poren umgewandelt wird, und indem das poröse Silizium (42, 44) anschließend einer Wärmebehandlung (45) unterzogen wird, in deren Verlauf sich die Poren an der ersten Oberfläche (12) zumindest weitgehend wieder schließen, wobei das dazu erforderliche Material aus einer tiefer liegenden Schicht (44) des porösen Siliziums stammt,
- Erzeugen einer Schaltungsstruktur (20) in dem definierten Waferabschnitt (18), und
- Heraustrennen des definierten Waferabschnitts (18) aus dem Kalbleiterwafer (10), wobei der Waferabschnitt (18) in einem ersten Prozessablauf so freigestellt wird, dass er nur noch über stegartige Verbindungen (24) an dem verbleibenden Halbleiterwafer (10) gehalten wird, und wobei die stegartigen Verbindungen (24) in einem zweiten Prozessablauf aufgetrennt werden,
**dadurch gekennzeichnet, dass** der Substratwafer (32) im Bereich der ersten Oberfläche (12) aus p-dotiertem Silizium (34) besteht, und dass in dem p-dotierten Silizium (34) des Substratwafers (32) eine Vielzahl von lokalen, n-dotierten Bereichen (38, 40) erzeugt wird, bevor das p-dotierte Silizium (34) mit Hilfe des anodischen Ätzprozesses in poröses Silizium (42, 44) umgewandelt wird, wobei eine erste Gruppe von punktuellen n-dotierten Bereichen (40) erzeugt wird, wobei zumindest ein punktueller n-dotierter Bereich im Bereich des definierten Waferabschnitts (18) angeordnet ist, und wobei ein ringförmiger n-dotierter Bereich (62) erzeugt wird, der konzentrisch an der Peripherie (64) des Substratwafers (32) angeordnet wird, wobei die punktuellen n-dotierten Bereiche (40) innerhalb des ringförmigen n-dotierten Bereichs (62) weitgehend gleichmäßig verteilt sind.

2. Verfahren nach Anspruch 1, **dadurch gekennzeichnet, dass** der Waferhohlraum unter dem definierten Waferabschnitt (18) als geschlossener Waferhohlraum (16; 44) erzeugt wird.

3. Verfahren nach einem der Ansprüche 1 oder 2, **dadurch gekennzeichnet, dass** nach der Wärmebehandlung (45) eine Epitaxieschicht (48) auf das poröse Silizium (46) aufgebracht wird, wobei die Schaltungsstruktur (20) zumindest überwiegend in der Epitaxieschicht (48) erzeugt wird.

4. Verfahren nach einem der Ansprüche 1 bis 3, **dadurch gekennzeichnet, dass** der definierte Waferabschnitt (18) nach dem Erzeugen der Schaltungsstruktur (20) so freigestellt wird, dass an einer seitlichen Peripherie des Waferabschnitts (18) stegartige, lokale Verbindungen (24) entstehen.

5. Verfahren nach einem der Ansprüche 1 bis 4, **dadurch gekennzeichnet, dass** der Waferabschnitt (18) in dem Halbleiterwafer (10) in [100]-Richtung oder in [110]-Richtung angeordnet wird und dass die stegartigen lokalen Verbindungen (24) an Ecken oder an Seitenkanten des Waferabschnitts (18) angeordnet werden.

6. Verfahren nach einem der Ansprüche 1 bis 5, **dadurch gekennzeichnet, dass** der definierte Waferabschnitt (18) mit Hilfe von Scherkräften aus dem verbleibenden Halbleiterwafer (10) herausgebrochen wird.

7. Verfahren nach Anspruch 6, **dadurch gekennzeichnet, dass** der definierte Waferabschnitt (18) mit Hilfe eines Greifwerkzeugs (52) herausgebrochen wird, das im Bereich seine Greiffläche in etwa genauso groß ausgebildet ist wie die laterale Flächenausdehnung (W) des Waferabschnitts (18).

8. Verfahren nach einem der Ansprüche 1 bis 7, **dadurch gekennzeichnet, dass** das p-dotierte Silizium (34) im Bereich des definierten Waferabschnitts (18) mit Hilfe des anodischen Ätzprozesses in eine obere Schicht (42) aus porösem Silizium mit einer Vielzahl von feineren Poren und in eine untere Schicht (44) mit einer Vielzahl von größeren Poren umgewandelt wird.

9. Verfahren nach einem der Ansprüche 1 bis 8, **dadurch gekennzeichnet, dass** der Substratwafer (32) an der ersten Oberfläche (12) eine obere Schicht (34) und eine darunter liegende untere Schicht (36) aufweist, wobei die obere Schicht (34) ein stärker p-dotiertes Silizium ist als die untere Schicht (36).

10. Verfahren nach einem der Ansprüche 1 bis 9, **dadurch gekennzeichnet, dass** der verbleibende Halbleiterwafer (10) nach dem Heraustrennen des definierten Waferabschnitts (18) abgeschliffen und als Substratwafer (32) für die Herstellung von weiteren integrierten Schaltungen (26) bereitgestellt wird.

11. Substratwafer zum Herstellen einer integrierten Schaltung (62), mit einer ersten und einer zweiten Oberfläche (12, 14) und mit einer Peripherie (64), wobei der Substratwafer im Bereich der ersten Oberfläche (12) aus p-dotiertem Silizium (34) besteht, unter dem sich ein zusammenhängender, geschlossener Hohlraum (44') befindet, ferner mit einem ringförmigen n-dotierten Bereich (62), der konzentrisch an der Peripherie (64) angeordnet ist, wobei innerhalb des ringförmigen n-dotierten Bereichs eine Vielzahl von lokalen, punktuellen n-dotierten Bereichen (40) weitgehend gleichmäßig verteilt sind, und wobei die punktuellen n-dotierten Bereiche (40) vertikale Stützstellen bilden, mit denen das p-dotierte Silizium (34) im Bereich der ersten Oberfläche (12) nach unten abgestützt ist.

## Claims

1. A method for producing an integrated circuit (26), comprising the steps:
- providing a semiconductor wafer (10) having a first and a second surface (12, 14),
- producing a wafer cavity (16; 44') below at least one defined wafer section (18) in the region of the first surface (12), by firstly providing a substrate wafer (32) which is converted, in the region of the defined wafer section (18), into porous silicon (42, 44) having a plurality of pores by means of an anodic etching process, and by subsequently subjecting the porous silicon (42, 44) to a thermal treatment (45), in the course of which the pores at least substantially close again at the first surface (12), wherein the material required for this originates from a more deeply situated layer (44) of the porous silicon
- producing a circuit structure (20) in the defined wafer section (18) and
- releasing the defined wafer section (18) from the semiconductor wafer (10), wherein the wafer section (18) is freed in a first process sequence in such a way that it is held only via web-like connections (24) on the remaining semiconductor wafer (10), and wherein the web-like connections (24) are severed in a second process sequence,
**characterized in that** the substrate wafer (32) is composed of p-doped silicon (34) in the region of the first surface (12), and **in that** a plurality of local n-doped regions (38, 40) are produced in the p-doped silicon (34) of the substrate wafer (32) before the p-doped silicon (34) is converted into porous silicon (42, 44) by means of the anodic etching process, wherein a first group of punctiform n-doped regions (40) are produced, wherein at least one punctiform n-doped region is arranged in the region of the defined wafer section (18), and wherein a ring-shaped n-doped region (62) is produced, which is arranged concentrically at the periphery (64) of the substrate wafer (32), wherein the punctiform n-doped regions (40) are distributed substantially uniformly within the ring-shaped n-doped region (62).

2. The method of claim 1, **characterized in that** the wafer cavity below the defined wafer section (18) is produced as a closed wafer cavity (16; 44).

3. The method of one of claims 1 or 2, **characterized in that** an epitaxial layer (48) is applied to the porous silicon (46) after the thermal treatment (45), wherein the circuit structure (20) is produced at least predominantly in the epitaxial layer (48).

4. The method of any of claims 1 to 3, **characterized in that**, after the circuit structure (20) has been produced, the defined wafer section (18) is freed in such a way that web-like local connections (24) remain at a lateral periphery of the wafer section (18).

5. The method of any of claims 1 to 4, **characterized in that** the wafer section (18) is arranged in the [100] direction or in the [110] direction in the semiconductor wafer (10), and the web-like local connections (24) are arranged at corners or at lateral edges of the wafer section (18).

6. The method of any of claims 1 to 5, **characterized in that** the defined wafer section (18) is broken out from the remaining semiconductor wafer by means of shear forces.

7. The method of claim 6, **characterized in that** the defined wafer section (18) is broken out by means of a gripping tool (52) which, in the region of its gripping area, is approximately just as large as the lateral area extent (W) of the wafer section (18).

8. The method of any of claims 1 to 7, **characterized in that** the p-doped silicon (34), in the region of the defined wafer section (18), is converted into an upper layer (42) composed of porous silicon having a plurality of finer pores and into a lower layer (44) having a plurality of larger pores by means of the anodic etching process.

9. The method of any of claims 1 to 8, **characterized in that** the substrate wafer (32) at the first surface (12) has an upper layer (34) and an underlying lower layer (36), wherein the upper layer (34) is a more heavily p-doped silicon than the lower layer (36).

10. The method of any of claims 1 to 9, **characterized in that** the remaining semiconductor wafer (10) is ground and provided as substrate wafer (32) for the production of further integrated circuits (26) after the defined wafer section (18) has been released.

11. A substrate wafer for producing an integrated circuit (26), comprising a first and a second surface (12, 14) and a periphery (64), wherein the substrate wafer, in the region of the first surface (12), is composed of p-doped silicon (34) below which a continuous closed cavity (44') is situated, and further comprising a ring-shaped n-doped region (62) which is arranged concentrically at the periphery (64), wherein a plurality of local punctiform n-doped regions (40) are distributed substantially uniformly, and wherein the punctiform n-doped regions (40) form vertical support connections supporting the p-doped silicon (34) in the region of the first surface (12).

## Revendications

1. Procédé pour produire un circuit intégré (26), comprenant les étapes suivantes:
- préparer une galette de semi-conducteur (10) avec une première et une deuxième surfaces (12, 14),
- produire une cavité de galette (16; 44') sous au moins une partie de galette définie (18) dans la région de la première surface (12), en préparant d'abord une galette de substrat (32), qui est convertie dans la région de la partie de galette définie (18), à l'aide d'un procédé de gravure anodique, en silicium poreux (42, 44) présentant une multiplicité de pores, et en soumettant ensuite le silicium poreux (42, 44) à un traitement thermique, au cours duquel les pores situés sur la première surface (12) se referment au moins largement, dans lequel le matériau nécessaire à cet effet provient d'une couche plus profonde (44) du silicium poreux,
- produire une structure de circuit (20) dans la partie de galette définie (18), et
- extraire la partie de galette définie (18) hors de la galette de semi-conducteur (10), dans lequel la partie de galette (18) est dégagée au cours d'une première opération, de telle manière qu'elle ne soit plus maintenue dans la galette de semi-conducteur (10) que par des liaisons en forme de nervures (24), et dans lequel les liaisons en forme de nervures (24) sont coupées dans une deuxième opération,
**caractérisé en ce que** la galette de substrat (32) se compose dans la région de la première surface (12) de silicium à dopage p (34), et **en ce que** l'on produit dans le silicium à dopage p (34) de la galette de substrat (32) une multiplicité de zones locales à dopage n (38, 40), avant que le silicium à dopage p (34) soit converti en silicium poreux (42, 44) à l'aide du procédé de gravure anodique, dans lequel on produit un premier groupe de zones ponctuelles à dopage n (40), dans lequel au moins une zone ponctuelle à dopage n est disposée dans la région de la partie de galette définie (18), et dans lequel on produit une zone annulaire à dopage n (62), qui est disposée de façon concentrique à la périphérie (64) de la galette de substrat (32), dans lequel les zones ponctuelles à dopage n (40) sont réparties de façon largement uniforme à l'intérieur de la zone annulaire à dopage n (62).

2. Procédé selon la revendication 1, **caractérisé en ce que** l'on produit la cavité de galette sous la partie de galette définie (18) sous la forme d'une cavité de galette fermée (16, 44).

3. Procédé selon l'une des revendications 1 ou 2, **caractérisé en ce que** l'on dépose, après le traitement thermique (45), une couche épitaxiale (48) sur le silicium poreux (46), dans lequel on produit la structure de circuit (20) au moins principalement dans la couche épitaxiale (48).

4. Procédé selon l'une quelconque des revendications 1 à 3, **caractérisé en ce que** l'on dégage la partie de galette définie (18) après la production de la structure de circuit (20), de telle manière qu'il apparaisse des liaisons locales en forme de nervures (24) à une périphérie latérale de la partie de galette (18).

5. Procédé selon l'une quelconque des revendications 1 à 4, **caractérisé en ce que** l'on dispose la partie de galette (18) dans la galette de semi-conducteur (10) dans la direction [100] ou dans la direction [110] et **en ce que** l'on dispose les liaisons locales en forme de nervures (24) aux coins ou aux arêtes latérales de la partie de galette (18).

6. Procédé selon l'une quelconque des revendications 1 à 5, **caractérisé en ce que** l'on extrait la partie de galette définie (18) hors du reste de la galette de semi-conducteur (10) à l'aide de forces de cisaillement.

7. Procédé selon la revendication 6, **caractérisé en ce que** l'on extrait la partie de galette définie (18) à l'aide d'un outil de saisie (52), qui est configuré dans la région de sa face de saisie avec sensiblement la même grandeur que l'extension de surface latérale (W) de la partie de galette (18).

8. Procédé selon l'une quelconque des revendications 1 à 7, **caractérisé en ce que** l'on convertit le silicium à dopage p (34) dans la région de la partie de galette définie (18) à l'aide du procédé de gravure anodique en une couche supérieure (42) en silicium poreux avec une multiplicité de pores plus fins et en une couche inférieure (44) avec une multiplicité de pores plus grands.

9. Procédé selon l'une quelconque des revendications 1 à 8, **caractérisé en ce que** la galette de substrat (32) présente sur la première surface (12) une couche supérieure (34) et en dessous de celle-ci une couche inférieure (36), dans lequel la couche supérieure (34) est du silicium à dopage p plus fort que la couche inférieure (36).

10. Procédé selon l'une quelconque des revendications 1 à 9, **caractérisé en ce que** l'on polit le reste de la galette de semi-conducteur (10) après l'extraction de la partie de galette définie (18) et on le prépare comme galette de substrat (32) pour la production d'autres circuits intégrés (26).

11. Galette de substrat pour la production d'un circuit intégré (62), avec une première et une deuxième surfaces (12, 14) et avec une périphérie (64), dans laquelle la galette de substrat se compose dans la région de la première surface (12) de silicium à dopage p (34), sous lequel il se trouve une cavité fermée continue (44'), en outre avec une zone annulaire à dopage n (62), qui est disposée de façon concentrique à la périphérie (64), dans laquelle une multiplicité de zones ponctuelles locales à dopage n (40) sont réparties de façon largement uniforme à l'intérieur de la zone annulaire à dopage n, et dans laquelle les zones ponctuelles à dopage n (40) forment des points d'appui verticaux, avec lesquels le silicium à dopage p (34) est soutenu vers le bas dans la région de la première surface (12).
